(19) **Europäisches Patentamt**
**European Patent Office**
**Office européen des brevets**

(11) **EP 4 080 284 A1**

(12) **EUROPEAN PATENT APPLICATION**

(43) Date of publication:
**26.10.2022 Bulletin 2022/43**

(21) Application number: **21169097.9**

(22) Date of filing: **19.04.2021**

(51) International Patent Classification (IPC):
***G03F 7/20*** *(2006.01)*

(52) Cooperative Patent Classification (CPC):
**G03F 7/70491; G03F 7/706; G03F 7/70633**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
- LIAN, Jin
  **5500 AH Veldhoven (NL)**
- KOOLEN, Armand, Eugene, Albert
  **5500 AH Veldhoven (NL)**

(74) Representative: **ASML Netherlands B.V.**
**Corporate Intellectual Property**
**P.O. Box 324**
**5500 AH Veldhoven (NL)**

(54) **METROLOGY TOOL CALIBRATION METHOD AND ASSOCIATED METROLOGY TOOL**

(57) Disclosed is a method of determining a correction for a measurement of a target and an associated apparatus. The measurement is subject to a target-dependent correction parameter which has a dependence the target and/or a stack on which the target is comprised. The method comprises obtaining first measurement data relating to a measurement of a fiducial target, said first measurement data comprising at least a first and second set of intensity parameter values; and second measurement data relating to a measurement of the fiducial target, the second measurement data comprising a third set of intensity parameter values. A target-invariant correction parameter is determined from said first measurement data and second measurement data, the target-invariant correction parameter being a component of the target-dependent correction parameter which is not dependent on the target and/or a stack; and the correction is determined from said target-invariant correction parameter.

Fig. 6

EP 4 080 284 A1

**Description**

FIELD

The present invention relates to metrology applications and in particular to metrology applications in the manufacture of integrated circuits.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k1 lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and $k_1$ is an empirical resolution factor. In general, the smaller $k_1$ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

During the manufacturing process there is a need to inspect the manufactured structures and/or to measure characteristics of the manufactured structures. Suitable inspection and metrology apparatuses are known, which include e.g., spectroscopic scatterometers and angularly resolved scatterometers. Spectroscopic scatterometers may direct a broadband radiation beam onto the substrate and measure the spectrum (intensity as a function of wavelength) of the radiation scattered into a particular narrow angular range. Angularly resolved scatterometers may use a monochromatic radiation beam and measure the intensity of the scattered radiation as a function of angle.

Asymmetry in the scatterometer (which shows up as sensor error or tool induced shift (TIS)), can cause difficulties in measuring overlay or other parameter of interest.

SUMMARY

In a first aspect of the invention, there is provided a method of determining a correction for a measurement of a target, the measurement being subject to a target-dependent correction parameter term which has a dependence the target and/or a stack on which the target is comprised, the method comprising: obtaining first measurement data relating to a measurement of a fiducial target, said first measurement data comprising at least a first set of intensity parameter values and a corresponding second set of intensity parameter values; obtaining second measurement data relating to a measurement of the fiducial target, the second measurement data comprising a third set of intensity parameter values; determining a target-invariant correction parameter from said first measurement data and second measurement data, the target-invariant correction parameter being a component of the target-dependent correction parameter which is not dependent on the target and/or a stack; and determining said correction from said target-invariant correction parameter.

Also disclosed is processing device and associated program storage, and a computer program, each comprising instructions for a processor which cause the processor to perform the method of the first aspect.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a scatterometry apparatus used as a metrology device, which may comprise a dark field and/or bright-field microscope according to embodiments of the invention;
- Figure 5 comprises (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay (DBO) measurements and (d) a third pair of illumination apertures combining the first and second pair of apertures
- Figure 6 depicts a schematic overview of a scatterometry apparatus used as a metrology device with an illumination arrangement able to perform the method of an embodiment;
- Figure 7 depicts a number of aperture profiles as defined by a moving aperture so as to provide an illumination arrangement able to perform the method of an embodiment; and
- Figure 8 depicts a block diagram of a computer system for controlling a system and/or method as disclosed herein.

DETAILLED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

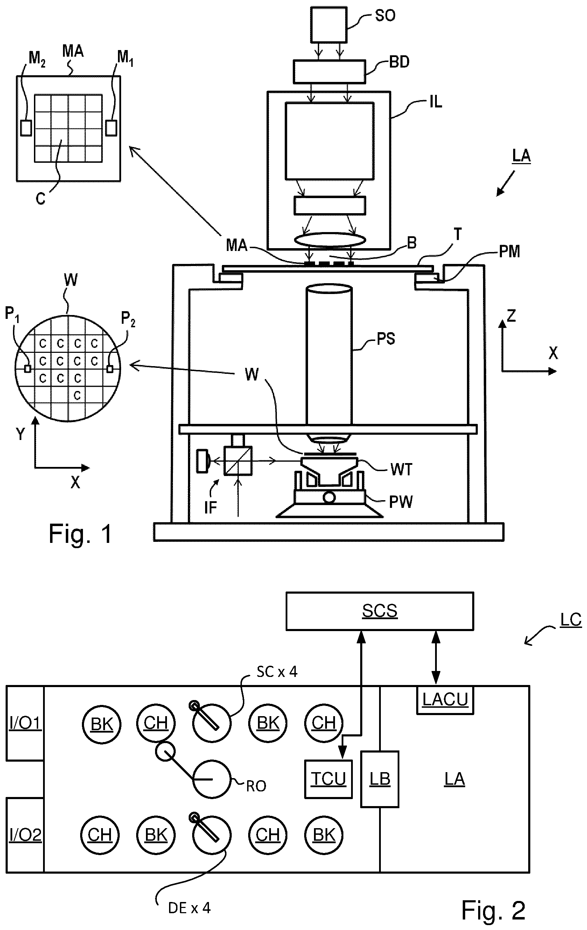

Figure 1 schematically depicts a lithographic apparatus LA. The lithographic apparatus LA includes an illumination system (also referred to as illuminator) ILL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system ILL receives a radiation beam from a radiation source SO, e.g. via a beam delivery system BD. The illumination system ILL may include various types of optical components, such as refractive, reflective, magnetic, electromagnetic, electrostatic, and/or other types of optical components, or any combination thereof, for directing, shaping, and/or controlling radiation. The illuminator ILL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

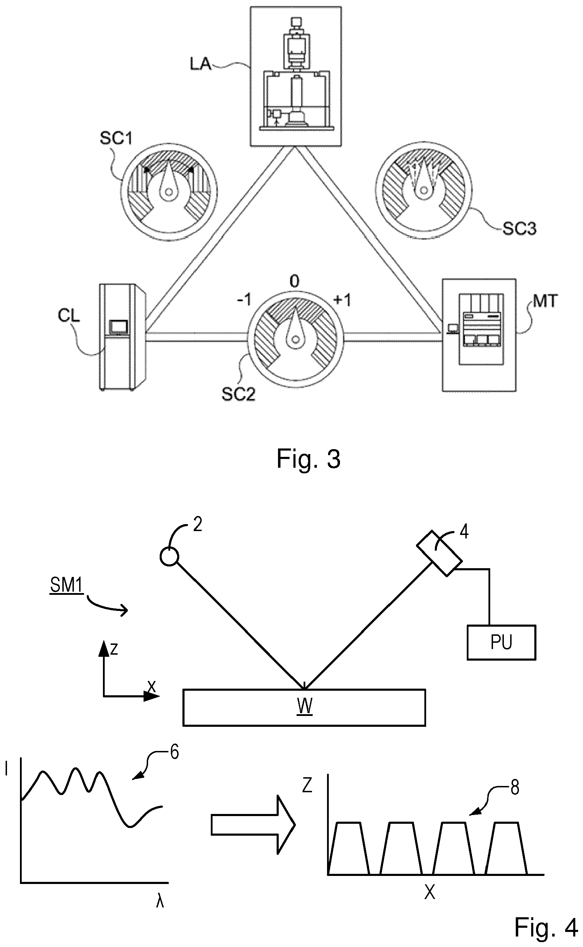

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is a ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

A metrology apparatus, such as a scatterometer, is depicted in Figure 4. It comprises a broadband (white light) radiation projector 2 which projects radiation onto a substrate W. The reflected or scattered radiation is passed to a spectrometer detector 4, which measures a spectrum 6 (i.e. a measurement of intensity as a function of wavelength) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

In order to monitor the lithographic process, parameters of the patterned substrate are measured. Parameters may include, for example, the overlay error between successive layers formed in or on the patterned substrate. This measurement may be performed on a product substrate and/or on a dedicated metrology target. There are various techniques for making measurements of the microscopic structures formed in lithographic processes, including the use of scanning electron microscopes and various specialized tools. A fast and non-invasive form of specialized inspection tool is a scatterometer in which a beam of radiation is directed onto a target on the surface of the substrate and properties of the scattered or reflected beam are measured.

Examples of known scatterometers include angle-resolved scatterometers of the type described in US2006033921A1 and US2010201963A1. The targets used by such scatterometers are relatively large, e.g., 40μm by 40μm, gratings and the measurement beam generates a spot that is smaller than the grating (i.e., the grating is underfilled). In addition to measurement of feature shapes by reconstruction, diffraction based overlay can be measured using such apparatus, as described in published patent application US2006066855A1. Diffraction-based overlay metrology using dark field imaging of the diffraction orders enables overlay measurements on smaller targets. Examples of dark field imaging metrology can be found in international patent applications WO 2009/078708 and WO 2009/106279 which documents are hereby incorporated by reference in their entirety. Further developments of the technique have been described in published patent publications US20110027704A, US20110043791A, US2011102753A1, US20120044470A, US20120123581A, US20130258310A, US20130271740A and WO2013178422A1. These targets can be smaller than the illumination spot and may be surrounded by product structures on a wafer. Multiple gratings can be measured in one image, using a composite grating target. The contents of all these applications are also incorporated herein by reference.

In a diffraction-based dark field metrology device, a beam of radiation is directed onto a metrology target and one or more properties of the scattered radiation are measured so as to determine a property of interest of the target. The properties of the scattered radiation may comprise, for example, intensity at a single scattering angle (e.g., as a function of wavelength) or intensity at one or more wavelengths as a function of scattering angle.

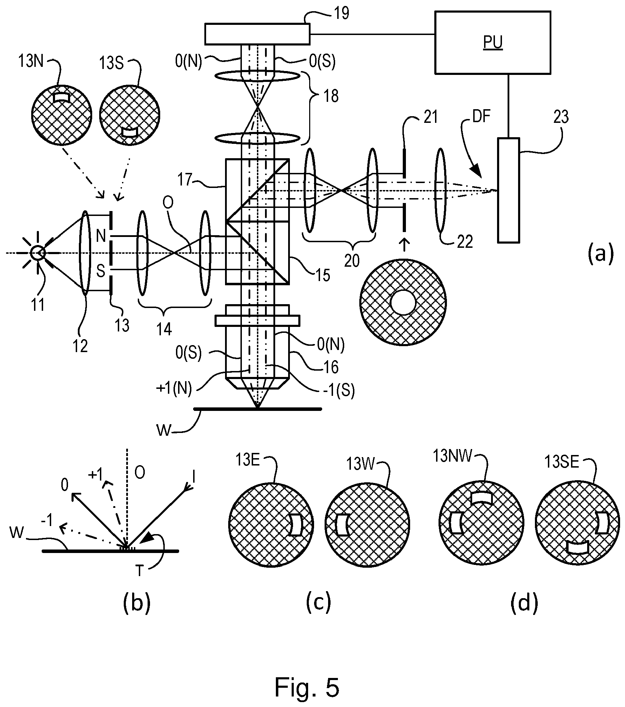

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least one of the first orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above

Measurement of targets in dark field metrology may comprise, for example, measuring the a first intensity of

the 1st diffraction order $I_{+1}$ and a second intensity of the -1st diffraction order ($I_{-1}$) and calculating an intensity asymmetry ($A = I_{+1} - I_{-1}$), which is indicative of asymmetry in the target. The metrology targets may comprise one or more grating structures from which a parameter of interest may be inferred from such intensity asymmetry measurements, e.g., the targets are designed such that the asymmetry in the target varies with the parameter of interest. For example, in overlay metrology a target may comprise at least one composite grating formed by at least a pair of overlapping sub-gratings that are patterned in different layers of the semiconductor device. Asymmetry of the target will therefore be dependent on alignment of the two layers and therefore overlay. Other targets may be formed with structures which are exposed with different degrees of variation based on the focus setting used during the exposure; the measurement of which enabling that focus setting to be inferred back (again through intensity asymmetry).

Metrology measurements, such as performed using apparatuses and methods described above, may be subject to a sensor error $\epsilon$ (sometimes this is referred to in the art as tool induced shift (TIS)) which may reduce the accuracy of the measurement. This sensor error $\epsilon$ is caused by the fact that sensor optics of the metrology sensor are not perfect and may be asymmetric.

A result of this sensor error is a contribution to the measured intensity signal. With respect to a dark field metrology measurement as just described, the asymmetry A now comprises this sensor error contribution: $A = I^{+1}(1 + \epsilon) - I^{-1}(1 - \epsilon)$, where $I_{+1}$ and $I_{-1}$ are the intensities of +1 and -1 diffraction orders in the absence of sensor error.

US7656518 (incorporated herein by reference) discloses a method of measuring and correcting for this sensor error. A target pattern (e.g., a grating or periodic structure) is illuminated twice: at a first substrate orientation (e.g., 0°) to obtain a first image and at as second substrate orientation that is 180° with respect to the first substrate orientation to obtain a second image. One of these images is rotated through 180° with respect to the other and is subtracted from the other image. In this way, asymmetry of the scatterometer can be corrected.

In a DBO setting (e.g., based on angularly resolved pupil plane measurements), the target pattern is illuminated with radiation and the intensity of resultant scattered radiation (usually integrated over time) is measured at the detector at a plurality of pre-determined positions (e.g., at each detector pixel) in a two dimensional array. The target portion is then rotated by about 180° in the plane of, or parallel to, the substrate (i.e., a plane substantially perpendicular to the optical axis of the sensor optics) and the measurement is made again. This rotation of the target portion may be achieved via rotation of either the substrate, the sensor or both. The sensor asymmetry may be calculated and stored on a pixel-by-pixel basis. This means that intensity measurements at 0° and 180° substrate rotation are made for each pixel to obtain a pair of two-dimensional angular scatter spectra, each pixel corresponding to respective angular positions relative to the target pattern. One of these two-dimensional angular scatter spectra is rotated by 180°. If there is no sensor asymmetry, then the rotated two-dimensional angular scatter spectrum should be identical to the other, non-rotated, angular scatter spectrum. Any sensor asymmetry or sensor error will show up as a difference between the two images. Therefore, an asymmetry error correction value (or sensor error correction value) for each pixel may be calculated by subtracting the intensity of one of the two dimensional angular scatter spectra from the other. This value may then be divided by 2 for each pixel.

For μDBO (micro diffraction based overlay), μDBO images are captured at an image plane. Typically a μDBO image may comprise one or more regions of interest (ROI), each ROI relating to a particular diffraction order. For example, a μDBO image may comprise two ROIs (e.g., a first ROI for a +1 diffraction order and a second ROI for a -1 diffraction order), or four ROIs (+1 and -1 orders for each of two grating directions). In other examples, the +1 and -1 orders may be imaged sequentially, in which case each μDBO image may comprise only a single ROI (one direction) or two ROIs (two directions). A single intensity value is typically determined for each ROI (e.g., as an average over the ROI). As such, the correction for sensor error in μDBO methods is based on a selected ROI and averaged intensity therein, and not on a pixel level. The remaining description will concentrate on a μDBO embodiment, although the concepts disclosed are applicable to DBO and other measurement methods (e.g., including measurement of other parameters such as focus, more specifically DBF and μDBF).

For 0 degree orientation, the measured intensities of the +1 and -1 diffraction orders are $I_0^{+1}(1 + \epsilon), -1$ and $I_0^{-1}(1 - \epsilon)$, respectively; and at the 180 degree orientation the measured intensities of the +1 and -1 diffraction orders are $I_{180}^{+1}(1 + \epsilon), -1$ and $I_{180}^{-1}(1 - \epsilon)$ respectively. Since the intensities in the absence of sensor error will be the same at the two orientations; i.e., $I_0^{+1} = I_{180}^{-1}$, $I_0^{-1} = I_{180}^{+1}$, then:

$$\left( (I_0^{+1}(1 + \epsilon) + I_{180}^{-1}(1 - \epsilon) \right)/2 = I_0^{+1};$$

and the sensor error (and therefore a corresponding correction value) can be determined from the measured intensities $I_0^{+1}(1 + \epsilon)$, $I_0^{-1}(1 - \epsilon)$, $I_{180}^{+1}(1 + \epsilon)$ and $I_{180}^{-1}(1 - \epsilon)$ as follows:

$$\epsilon = \frac{(I_0^{+1}(1 + \epsilon) - I_{180}^{-1}(1 - \epsilon))}{(I_0^{+1}(1 + \epsilon) + I_{180}^{-1}(1 - \epsilon))}$$

The correction value can be used directly in correcting further measurements of target portions with 0° of substrate rotation. This may be done by dividing the measured intensity value(s) with (1 + $\epsilon$) or (1 + $\epsilon$) as appropriate. It is possible to save the correction value and apply it to many measurements thereby reducing impact on throughput. This is because the correction value is substantially invariant with time.

The calibration method described requires the sampling of a large number of targets on the wafer, in order to set up each correction recipe. On top of that, the method is also strongly target-dependent; this means that the tool requires re-calibration for each different use cases (e.g., for different stacks as the stack changes). In other words, the sensor error correction parameter depends on local changes in the stack. Because the stack may change quickly during a lithographic process, a new calibration should be performed at regular intervals. This requires a large number of wafer rotations, which takes a lot of expensive stage and measurement time.

It is desirable to perform sensor error calibration with a lower requirement for stage time and/or number of wafer rotations.

The method comprises determining a target-invariant correction parameter $\epsilon(p_x,p_y)$ for a sensor or metrology apparatus. This describes a universal sensor error contribution due to the sensor optics corresponding to illumination via an illumination location or pixel $p_x,p_y$ of the illumination pupil (e.g., a Fourier plane or angularly resolved plane of the detection optics). Illumination from each single illumination pixel or location will have a unique path through the sensor (detection) optics. Note that the sensor error itself is a parameter which is not target dependent, it is purely caused by lens aberrations, system transmission, etc.. The calibration/determination of the sensor error requires the use of a target and as consequence, the calibration/determined correction is effectively target dependent. Described herein is a calibration method that can decouple the target contribution from the determined sensor error contribution.

It can be shown that the actual, target-dependent correction parameter $\epsilon_{TD}(p_x,p_y)$ is a combination of this target-invariant correction parameter $\epsilon(p_x,p_y)$ and a target-dependent distribution of intensities $W_{TD}(p_x,p_y)$ of the scattered light by a specific structure and/or stack in the detection pupil plane. Target-dependent in this context describes being structure and/or stack dependent, i.e., a dependence on the sample or structure being measured. More specifically the target-dependent correction parameter $\epsilon_{TD}(p_x,p_y)$ (e.g., the sensor error) is the product of this target-invariant correction parameter $e(p_x,p_y)$ and target-dependent distribution of intensities $W_{TD}(p_x,p_y)$; i.e.:

$$\epsilon_{TD}(p_x, p_y) = W_{TD}(p_x, p_y)\epsilon(p_x, p_y)$$

As such, the sensor error for a target A would be $\epsilon_A(p_x,p_y) = W_A(p_x,p_y)\epsilon(p_x,p_y)$, and the sensor error for a target B would be $\epsilon_B(p_x,p_y) = W_B(p_x,p_y)\epsilon(p_x,p_y)$. For µDBO measurements, there will typically be only one value for $\epsilon_{TD}$ rather than a per-pixel distribution (e.g., an average intensity over an ROI). In DBO, $\epsilon(p_x,p_y)$ may be directly measured as DBO is based on a pupil measurement.

The method comprises determining a target- dependent correction parameter for a reference or a fiducial target from first measurement data relating to said fiducial target to obtain a (target-dependent) fiducial correction parameter $\epsilon_{FID}(p_x,p_y)$. The first measurement data may comprise a first set of intensity parameter values relating to point illumination over a first plurality of point illumination locations in a pupil plane, and a second set of intensity parameter values relating to point illumination over a second plurality of point illumination locations in a pupil plane. Each location in the first plurality of point illumination locations has a corresponding point symmetrical location in the second plurality of point illumination locations. For example, the first set of intensity parameter values may be obtained from point illumination over the first plurality of point illumination locations located in a first region (e.g., a first half) of the illumination pupil and the second set of intensity parameter values may be obtained from point illumination over the second plurality of point illumination locations located in a second region (e.g., a second half) of the illumination pupil, the second region being located point symmetrically in the illumination pupil to the first region. Further description as to how the first set of intensity parameter values and second set of intensity parameter values may be obtained is disclosed later herein.

The method also comprises measuring second metrology data on the same fiducial target, the second metrology data comprising a third set of intensity parameter values or fiducial target-dependent distribution of intensities $W_{FID}(p_x,p_y)$ (e.g., an angularly resolved distribution of intensities). Once these quantities have been measured, the relationship above may be used to determine the target-invariant correction parameter $\epsilon(p_x,p_y)$ for the sensor optics (i.e., dividing

$\epsilon_{FID}(p_x,p_y)$ by $W_{FID}(p_x,p_y)$). In this way, the error contribution of the optics is separated from the error contribution of stack changes. The intensity parameter may be intensity as captured on a detector, or a related metric (e.g., normalized or otherwise processed intensity). Further description as to how the third set of intensity parameter values may be obtained is disclosed later herein.

The fiducial may be any suitable diffractive structure (e.g., a grating) and may be located on, for example, a wafer stage of the metrology apparatus (e.g., outside of the periphery of a loaded wafer on the wafer stage). In a specific example, the fiducial may comprise a small portion of silicon comprising a diffractive structure in resist thereon. The fiducial may be mounted on a rotatable portion of the wafer stage, such that the fiducial may be rotated (e.g., through 180 degrees) independently of wafer stage and/or wafer. However, if the fiducial is known to be sufficiently symmetrical, it may be that no rotation of the fiducial is required for the calibration.

Measuring $\epsilon_{FID}(p_x,p_y)$ is not straightforward using scatterometer apparatuses as have been described (e.g., in relation to Figure 5) which typically use incoherent illumination modes. Instead, an embodiment comprises using a scatterometer apparatus with an illumination arrangement optimized for this sensor error calibration. Such an illumination may comprise a directable point illumination source or narrow beam of radiation (e.g., coherent) which can be scanned over the illumination pupil (e.g., a first plurality of point illumination locations and said second plurality of point illumination locations). Such an illumination point source or beam of radiation may therefore be a laser beam or otherwise laser-like and have a small etendue, and may be used in a partially coherent illumination mode to perform partially coherent imaging; integrating the time trace of a full scan of the point illumination source over the pupil is equivalent to partial coherent imaging. The area of each point illumination location or the area of the illumination beam within the illumination pupil may, for example, correspond to a single pixel or small number of pixels, e.g., fewer than 5 or fewer than 3, of a detector in a detection pupil plane (or equivalent plane), assuming such a detector is present.

At each point illumination location along the illumination pupil scan path within the illumination pupil, an image, e.g., as measured using an imaging branch (detector at an image plane) or pupil branch (detector at a pupil plane) is captured. In a specific implementation, for example, at each of these locations, a μDBO image is obtained, from which an intensity parameter value is determined (e.g., as an average within an ROI). As such, each intensity parameter value within said first set of intensity parameter values may be obtained from a μDBO image obtained from point illumination at a particular location in a first portion of the illumination pupil and each intensity parameter value within said second set of intensity parameter values may be obtained from a μDBO image obtained from point illumination at a particular location in a second portion of the illumination pupil, such that there is an intensity parameter value in the second set corresponding to each intensity parameter value in the first set in that the corresponding values relate to illumination from point symmetrical illumination locations in the illumination pupil.

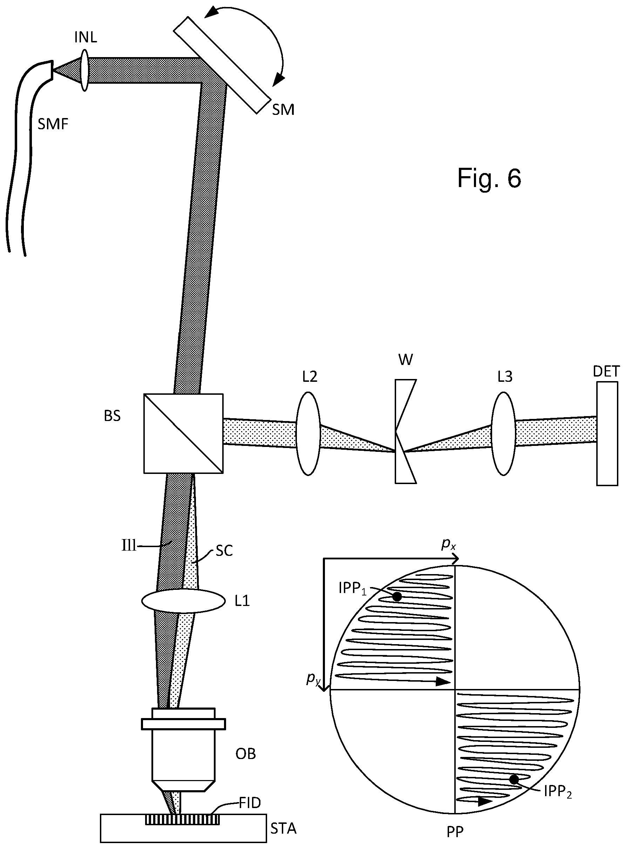

At each of the point illumination locations, the illumination radiation and resultant scattered radiation (having been scattered/diffracted by the fiducial) will travel through a unique path through the sensor optics. The target-dependent correction parameter for the fiducial $\epsilon_{FID}(p_x,p_y)$ can be calculated from each point symmetric pair (i.e., pairs of illumination pupil points which are symmetrical around the center of the illumination pupil, wherein each point symmetric pair corresponds to a different pixel described by pixel coordinates $p_x,p_y$ relating to one half of the illumination pupil or the first (or second) plurality of point illumination locations as illustrated in Figure 6). For the example of a single orientation fiducial method (i.e., where the fiducial has a high degree of symmetry), this can be done using the relationships:

$$I^*_{+1}(p_x,p_y) = I_{+1}(p_x,p_y)\big(1 + \epsilon_{FID}(p_x,p_y)\big),$$

$$I^*_{-1}(p_x,p_y) = I_{-1}(p_x,p_y)\big(1 - \epsilon_{FID}(p_x,p_y)\big)$$

Where $I^*_{+1}(p_x,p_y)$ and $I^*_{-1}(p_x,p_y)$ are respectively the first set of intensity parameter values over a first plurality of point illumination locations and second set of intensity parameter values over a corresponding (point symmetrical) second plurality of point illumination locations. $I_{+1}(p_x,p_y)$, $I_{-1}(p_x,p_y)$ are the intensities which would have been measured in the absence of sensor error (i.e., using a symmetrical sensor). These equations can be solved for $\epsilon_{FID}(p_x,p_y)$ from the measured intensity values, provided that the fiducial is sufficiently symmetrical such that it may be assumed $I_{+1} = I_{-1}$ for each coordinate $(p_x,p_y)$.

Where the the fiducial is not so symmetrical, or at least cannot be assumed so, then the fiducial is measured at first and second orientations to obtain measured values $I^*_{+1,0}$, $I^*_{-1,0}$, $I^*_{+1,180}$, $I^*_{-1,180}$ (where the suffix 0, 180 refers to the orientation), and therefore two further sets of intensity parameter values (a fourth set and a fifth set of intensity parameter values) are obtained, the fourth set corresponding to the first set at the opposite orientation and the fifth set corresponding to the second set at the opposite orientation. The target-dependent correction parameter for the fiducial $\epsilon_{FID}(p_x,p_y)$ can be determined from the relationships:

$$I^*_{+1,0}(p_x,p_y) = I_{+1}(p_x,p_y)\big(1 + \epsilon_{FID}(p_x,p_y)\big),$$

$$I^*_{-1,0}(p_x,p_y) = I_{-1}(p_x,p_y)\big(1 - \epsilon_{FID}(p_x,p_y)\big),$$

$$I^*_{+1,180}(p_x,p_y) = I_{+1}(p_x,p_y)\big(1 + \epsilon_{FID}(p_x,p_y)\big),$$

$$I^*_{-1,180}(p_x,p_y) = I_{-1}(p_x,p_y)\big(1 - \epsilon_{FID}(p_x,p_y)\big).$$

The measured intensities (i.e., the first, second, fourth and fifth sets of intensity parameter values relating to a point illumination source) may be detected by a camera in the detection pupil plane or detection image plane (e.g., μDBO-type measurements). The latter is possible because, when a certain point in the illumination pupil is illuminated, it has a unique path through the optics (given a certain target with a certain pitch) and, as such, the measured total intensity in the image plane is the intensity of a unique point in the detection pupil plane.

Figure 6 is a proposed metrology device which may be used to perform the fiducial based calibration as described. The device is shown in simplified form and may resemble the device of Figure 5 except in terms of the illumination arrangement. Coherent (or partially coherent) illumination radiation ILL may be delivered by a single mode fiber SMF (or other suitable delivery method) to an input lens INL and directing element or scanning mirror (or galvanic mirror) SM. A scanning mirror is one of several examples of a directing element. Another option may comprise a (e.g., phase) spatial light modulator (SLM) which adds programmable phase gradient onto the wave front. A binary amplitude SLM (e.g., digital micro mirror device DMD) may also be used to modulate the phase. This scanning mirror SM or directing element is controlled to scan the illumination Ill over the illumination pupil. The scanned beam is transported to the fiducial FID (or other target) on stage STA via beam splitter BS, lens system L1 and objective lens OB. The scattered radiation SC is directed by beamsplitter BS to a pupil imaging branch comprising lens system L2, L3, wedges W and detector DET.

Also shown on Figure 6 is pupil plane PP. In a specific arrangement illustrated, the illumination pupil comprises the top left and bottom right quadrants of a pupil plane (or a conjugate thereto) of the objective lens OB. The other two quadrants define the detection pupil. This is purely an example arrangement and other illumination pupil profiles are possible, including those where the illumination does not go through the objective lens OB. The actual illumination arrangement is not important to the concepts disclosed herein. The scanned illumination path is shown as a meander through both illumination quadrants. The sensor term $\epsilon_{FID}(p_x,p_y)$ is calculated from the pair of intensity values of a point symmetric pair of illumination pupil points for each pixel coordinate $(p_x,p_y)$ within the pupil. As such, for the example coordinate system used herein, the pixel coordinates shown only describe a first portion or half of the illumination pupil (one quadrant) relating to the first plurality of point illumination locations and first set of intensity parameter values. The second plurality of point illumination locations (relating to the second plurality of point illumination locations) are each assigned the coordinate of its point symmetrical location in the first plurality of point illumination locations. For illustration a single such pair of illumination pupil points $IPP_1$, $IPP_2$ is shown. Other aspects of the illumination branch may take the form of the illumination branch of Figure 5, e.g., it may comprise the elements labeled 12, 13 and 14 elements between input lens INL and scanning mirror SM.

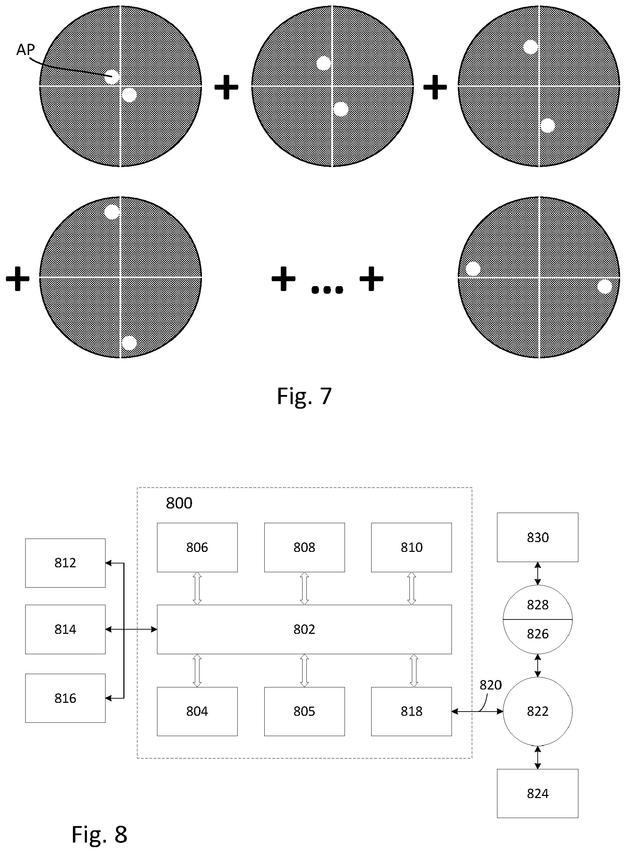

Figure 7 illustrates a further illumination concept for determining sensor term $\epsilon_{FID}(p_x,p_y)$. This approach may be used with the apparatus of Figure 5 (or similar) with the illumination branch as illustrated in that Figure. To obtain the necessary scanning beam (illumination point source) from such an illumination branch, one or two moving apertures may be provided. The Figure shows the apertures AP in five different positions in the illumination pupil (again illustrated here as two quadrants of the objective pupil); there will of course be many more positions over a complete scan to cover the illumination pupil. Note that this illustrated example shows simultaneous illumination in two directions (two apertures providing two illumination point sources). This is not essential, but of course halves the measurement time. The aperture size may match the width of the Fourier transform of an illumination mode selector of the metrology device.

The quantity $W_{FID}(p_x,p_y)$ (i.e., the third set of intensity parameter values) can be measured (e.g., directly) using a conventional pupil plane measurement, e.g., using the pupil imaging branch of the apparatus of Figure 5 or Figure 6 to obtain an angularly resolved intensity distribution. In the latter case, the incoherent illumination mode typically used for such measurements may be approximated by a partially incoherent mode comprising integrating the measured intensity on the detector during a fast scan of the point illumination source over the illumination pupil during capture. Alternatively this information may be obtained via an imaging branch detector (image sensor) by integrating per point or location of the illumination pupil, which corresponds to a point in the detection pupil.

Once the target-invariant correction parameter $\in(p_x,p_y)$ is determined, it can be combined with a pupil intensity measurement (target measurement data comprising a set of target intensity parameter values) from a particular target (e.g., target C) $W_C(p_x,p_y)$, to determine the target-dependent correction parameter $\in_C(p_x,p_y)$ (i.e., as target correction for sensor error specifically for that target/stack). No wafer rotation is necessary for this calibration. This target-dependent correction parameter $\in_C(p_x,p_y)$ can then be used to correct measurements of from target C, e.g., by dividing the target-dependent correction parameter $\in_C(p_x,p_y)$ for each pixel from the intensity value measured for the respective pixel. It is possible to save the asymmetry correction values for each of the pixels and apply those correction values to many measurements of the target C. The set of target intensity parameter values may be obtained in the same manner as the third set of intensity parameter values, but using a target rather than a fiducial for the measurement, and as such may be measured in a pupil plane or image plane.

This calibration can be repeated as often as necessary (e.g., as often as the process results in the target/stack changing sufficiently to require calibration). It should be appreciated that the fiducial used to determine the target-invariant correction parameter $\in(p_x,p_y)$ should have the same pitch as the target it is then used to calibrate for.

In summary, performing sensor error (TIS) calibration on a fiducial will significantly reduce the measurement burden and design complexity. At most, only the fiducial is required to be rotatable, and if sufficiently symmetrical, even this is not necessary. Also, it should be appreciated that performing sensor error correction on a fiducial will also enable sensor design simplicity and the lowering of the associated cost of such a sensor. A "wafer rotation" actually comprising rotating and repositioning the wafer. For example a target at the edge of the wafer will move to the other side with respect to the sensor after the wafer rotation and the sensor or stage has to travel the full range of the wafer. This becomes a constraint in the sensor or stage design.

Figure 8 is a block diagram that illustrates a computer system 800 that may assist in implementing the methods and flows disclosed herein. Computer system 800 includes a bus 802 or other communication mechanism for communicating information, and a processor 804 (or multiple processors 804 and 805) coupled with bus 802 for processing information. Computer system 800 also includes a main memory 806, such as a random access memory (RAM) or other dynamic storage device, coupled to bus 802 for storing information and instructions to be executed by processor 804. Main memory 806 also may be used for storing temporary variables or other intermediate information during execution of instructions to be executed by processor 804. Computer system 800 further includes a read only memory (ROM) 808 or other static storage device coupled to bus 802 for storing static information and instructions for processor 804. A storage device 810, such as a magnetic disk or optical disk, is provided and coupled to bus 802 for storing information and instructions.

Computer system 800 may be coupled via bus 802 to a display 812, such as a cathode ray tube (CRT) or flat panel or touch panel display for displaying information to a computer user. An input device 814, including alphanumeric and other keys, is coupled to bus 802 for communicating information and command selections to processor 804. Another type of user input device is cursor control 816, such as a mouse, a trackball, or cursor direction keys for communicating direction information and command selections to processor 804 and for controlling cursor movement on display 812. This input device typically has two degrees of freedom in two axes, a first axis (e.g., x) and a second axis (e.g., y), that allows the device to specify positions in a plane. A touch panel (screen) display may also be used as an input device.

One or more of the methods as described herein may be performed by computer system 800 in response to processor 804 executing one or more sequences of one or more instructions contained in main memory 806. Such instructions may be read into main memory 806 from another computer-readable medium, such as storage device 810. Execution of the sequences of instructions contained in main memory 806 causes processor 804 to perform the process steps described herein. One or more processors in a multiprocessing arrangement may also be employed to execute the sequences of instructions contained in main memory 806. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor 804 for execution. Such a medium may take many forms, including but not limited to, non-volatile media, volatile media, and transmission media. Non-volatile media include, for example, optical or magnetic disks, such as storage device 810. Volatile media include dynamic memory, such as main memory 806. Transmission media include coaxial cables, copper wire and fiber optics, including the wires that comprise bus 802. Transmission media can also take the form of acoustic or light waves, such as those generated during radio frequency (RF) and infrared (IR) data communications. Common forms of computer-readable media include, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge, a carrier wave as described hereinafter, or any other medium from which a computer can read.

Various forms of computer readable media may be involved in carrying one or more sequences of one or more instructions to processor 804 for execution. For example, the instructions may initially be borne on a magnetic disk of a remote computer. The remote computer can load the instructions into its dynamic memory and send the instructions over a telephone line using a modem. A modem local to computer system 800 can receive the data on the telephone line and use an infrared transmitter to convert the data to an infrared signal. An infrared detector coupled to bus 802 can receive the data carried in the infrared signal and place the data on bus 802. Bus 802 carries the data to main memory 806, from which processor 804 retrieves and executes the instructions. The instructions received by main memory 806 may optionally be stored on storage device 810 either before or after execution by processor 804.

Computer system 800 also preferably includes a communication interface 818 coupled to bus 802. Communication interface 818 provides a two-way data communication coupling to a network link 820 that is connected to a local network 822. For example, communication interface 818 may be an integrated services digital network (ISDN) card or a modem to provide a data communication connection to a corresponding type of telephone line. As another example, communication interface 818 may be a local area network (LAN) card to provide a data communication connection to a compatible LAN. Wireless links may also be implemented. In any such implementation, communication interface 818 sends and receives electrical, electromagnetic or optical signals that carry digital data streams representing various types of information.

Network link 820 typically provides data communication through one or more networks to other data devices. For example, network link 820 may provide a connection through local network 822 to a host computer 824 or to data equipment operated by an Internet Service Provider (ISP) 826. ISP 826 in turn provides data communication services through the worldwide packet data communication network, now commonly referred to as the "Internet" 828. Local network 822 and Internet 828 both use electrical, electromagnetic or optical signals that carry digital data streams. The signals through the various networks and the signals on network link 820 and through communication interface 818, which carry the digital data to and from computer system 800, are exemplary forms of carrier waves transporting the information.

Computer system 800 may send messages and receive data, including program code, through the network(s), network link 820, and communication interface 818. In the Internet example, a server 830 might transmit a requested code for an application program through Internet 828, ISP 826, local network 822 and communication interface 818. One such downloaded application may provide for one or more of the techniques described herein, for example. The received code may be executed by processor 804 as it is received, and/or stored in storage device 810, or other non-volatile storage for later execution. In this manner, computer system 800 may obtain application code in the form of a carrier wave.

Further embodiments are discussed in the subsequent list of numbered clauses:

1. A method of determining a target-dependent correction parameter for a measurement of a target, the measurement being subject to a target-dependent sensor error contribution which has a dependence on the target and/or a stack on which the target is comprised, the method comprising:

obtaining first measurement data relating to a measurement of a fiducial target, said first measurement data comprising at least a first set of intensity parameter values and a corresponding second set of intensity parameter values;

obtaining second measurement data relating to a measurement of the fiducial target, the second measurement data comprising a third set of intensity parameter values;

determining a target-invariant correction parameter from said first measurement data and second measurement data, the target-invariant correction parameter being a component of the target-dependent correction parameter which is not dependent on the target and/or a stack; and determining said target-dependent correction parameter from said target-invariant correction parameter.

2. A method as defined in clause 1, comprising capturing said second measurement data by illuminating said fiducial target and detecting said third set of intensity parameter values from said scattered radiation, said third set of intensity parameter values comprising an angularly resolved intensity parameter distribution.

3. A method as defined in clause 2, wherein said illuminating said fiducial target comprises illuminating the target with incoherent radiation.

4. A method as defined in clause 2, wherein said illuminating said fiducial target comprises illuminating said fiducial target with a point radiation source scanned over an illumination pupil.

5. A method as defined in clause 4, comprising integrating radiation scattered from said fiducial target over the scan on a detector in said detection pupil plane.

6. A method as defined in any of clauses 2 to 5, comprising:
detecting said third set of intensity parameter values at a detection pupil plane.

7. A method as defined in clause 4, comprising detecting said third set of intensity parameter values at an image plane by integrating radiation scattered from said fiducial target per point of the illumination pupil.

8. A method as defined in any preceding clause, wherein said determining a target-invariant correction parameter comprises determining a fiducial correction parameter from said first measurement data, said fiducial correction parameter comprising a target-dependent correction parameter relating to said fiducial target; and
determining said target-invariant correction parameter from said fiducial correction parameter and said second measurement data.

9. A method as defined in clause 8, wherein determining said target-invariant correction parameter comprises dividing the fiducial correction parameter by said second measurement data.

10. A method as defined in any of clauses 8 or 9, wherein said first set of intensity parameter values relates to an intensity value obtained using at least one point illumination source at each of a first plurality of point illumination locations within an illumination pupil and the second set of intensity parameter values relates to an intensity value obtained using the at least one point illumination source at each of a second plurality of point illumination locations within the illumination pupil, wherein each location in the first plurality of point illumination locations has a corresponding point symmetrical location in the second plurality of point illumination locations such that said first plurality of point illumination locations and said second plurality of point illumination locations together comprise a plurality of point symmetrical pairs of point illumination locations.

11. A method as defined in clause 10, wherein said fiducial correction parameter is determined from pairs of said intensity parameter values, each pair of intensity parameter values comprising: an intensity parameter value from said first set of intensity parameter values and an intensity parameter value from said second set of intensity parameter values and corresponding to each of said point symmetric pairs of point illumination locations.

12. A method as defined in clause 10 or 11, comprising capturing said first measurement data by scanning the at least one point illumination source over said first plurality of point illumination locations and said second plurality of point illumination locations, and obtaining an intensity parameter value from an image captured at each of said first and second plurality of point illumination locations .

13. A method as defined in clause 12, wherein scanning said at least one point illumination source comprises moving at least one illumination aperture within said illumination pupil.

14. A method as defined in clause 12, wherein scanning said at least one point illumination source comprises directing the at least one point illumination source over said first plurality of point illumination locations and said second plurality of point illumination locations using a directing element.

15. A method as defined in any of clauses 10 to 14, wherein said first set of intensity parameter values and said second set of intensity parameter values each relates to a first orientation of the fiducial target with respect to sensor optics used to obtain said first measurement data, and said first measurement data further comprises a fourth set of intensity parameter values and a fifth set of intensity parameter values, each relating to intensity values obtained using the at least one point illumination source at each of said first plurality of point illumination locations and said second plurality of point illumination locations respectively, for a second orientation of the fiducial target with respect to said sensor optics.

16. A method as defined in any of clauses 1 to 14, wherein said first measurement data relates to only a first orientation of the fiducial target.

17. A method as defined in any preceding clause, wherein said step of determining a target-dependent correction parameter comprises determining a target-dependent correction parameter for a target, the step comprising:

obtaining target measurement data comprising a set of target intensity parameter values relating to measurement of said target; and
determining said target-dependent correction parameter for said target from a combination of said set of target intensity parameter values and said target-invariant correction parameter.

18. A method as defined in clause 17, comprising capturing said target measurement data by illuminating said target and detecting said set of target intensity parameter values as an angularly resolved intensity value distribution from scattered radiation detected in a detection pupil plane.

19. A method as defined in clause 17, comprising capturing said target measurement data by illuminating said target with a point radiation source scanned over an illumination pupil and detecting said set of target intensity parameter values at an image plane by integrating radiation scattered from said target per point of the illumination pupil.

20. A method as defined in clause 18 or 19, wherein said target-dependent correction parameter is determined from the product of said set of target intensity parameter values and said target-invariant correction parameter.

21. A method as defined in any of clauses 17 to 20, comprising correcting measurements of said target using said target-dependent correction parameter.

22. A computer program comprising instructions for a processor which cause the processor and/or associated apparatus to perform the method of any preceding clause.

23. A processing device and associated program storage, said program storage comprising instructions for the processor which cause the processor to perform the method of any of clauses 1 to 21.

24. A metrology apparatus for determining a characteristic of interest of a target, said metrology apparatus comprising the processing device of clause 23.

25. A metrology apparatus for determining a characteristic of interest of a target, being operable to perform the method of any one of the clauses 1 to 21, the metrology apparatus comprising a point illumination source, said point illumination source comprising:

a directing element operable to receive an illumination beam and controllably direct, within an illumination pupil of the metrology apparatus, the illumination beam onto a substrate.

26. A metrology apparatus as defined in clause 25, wherein the directing element comprises a scanning mirror or spatial light modulator.

27. A metrology apparatus as defined in clause 25 or 26, wherein said point illumination source comprises a coherent or partially coherent radiation source to provide said illumination beam to said directing element.

28. A metrology apparatus as defined in clause 25, 26 or 27, wherein the point illumination source is operable in a first mode of operation where the illumination beam is scanned within said illumination pupil over a plurality of point illumination locations; the metrology apparatus being further operable to capture images for each of said point illumination locations.

29. A metrology apparatus as defined in clause 28, wherein the point illumination source is operable in a second mode of operation where the illumination beam is scanned within said illumination pupil at a scanning speed faster than in said first mode of operation; the metrology apparatus being further operable to capture an image relating to an integration of radiation scattered during said scanning.

30. A metrology apparatus as defined in any of clauses 25 to 29, comprising:

at least a first detector being operable to capture scattered radiation at an imaging plane of the metrology apparatus, said scattered radiation having been scattered by a target subsequent to receiving said illumination beam; and
at least a second detector being operable to capture said scattered radiation at a pupil plane of the metrology apparatus.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

The targets or target structures (more generally structures on a substrate) described herein may be metrology targets specifically designed and formed for the purposes of measurement. In other embodiments, properties of interest may be measured on one or more structures which are functional parts of devices formed on the substrate. Many devices have regular, grating-like structures. The terms target, target grating and target structure as used herein do not require that the target has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A method of determining a target-dependent correction parameter for a measurement of a target, the measurement being subject to a target-dependent sensor error contribution which has a dependence on the target and/or a stack on which the target is comprised, the method comprising:

   obtaining first measurement data relating to a measurement of a fiducial target, said first measurement data comprising at least a first set of intensity parameter values and a corresponding second set of intensity parameter values;
   obtaining second measurement data relating to a measurement of the fiducial target, the second measurement data comprising a third set of intensity parameter values;
   determining a target-invariant correction parameter from said first measurement data and second measurement data, the target-invariant correction parameter being a component of the target-dependent correction parameter which is not dependent on the target and/or a stack; and
   determining said target-dependent correction parameter from said target-invariant correction parameter.

2. A method as claimed in claim 1, comprising capturing said second measurement data by illuminating said fiducial target and detecting said third set of intensity parameter values from said scattered radiation, said third set of intensity parameter values comprising an angularly resolved intensity parameter distribution.

3. A method as claimed in claim 2, wherein one of:

   - said illuminating said fiducial target comprises illuminating the target with incoherent radiation, and
   - said illuminating said fiducial target comprises illuminating said fiducial target with a point radiation source scanned over an illumination pupil, and wherein, optionally, comprising integrating radiation scattered from said fiducial target over the scan on a detector in said detection pupil plane.

4. A method as claimed in any preceding claim, comprising:

   detecting said third set of intensity parameter values at a detection pupil plane, and
   optionally comprising detecting said third set of intensity parameter values at an image plane by integrating radiation scattered from said fiducial target per point of the illumination pupil.

5. A method as claimed in any preceding claim, wherein said determining a target-invariant correction parameter comprises determining a fiducial correction parameter from said first measurement data, said fiducial correction parameter comprising a target-dependent correction parameter relating to said fiducial target; and determining said target-invariant correction parameter from said fiducial correction parameter and said second measurement data.

6. A method as claimed in claim 5, wherein determining said target-invariant correction parameter comprises dividing the fiducial correction parameter by said second measurement data.

7. A method as claimed in any of claims 5 or 6, wherein said first set of intensity parameter values relates to an intensity value obtained using at least one point illumination source at each of a first plurality of point illumination locations within an illumination pupil and the second set of intensity parameter values relates to an intensity value obtained using the at least one point illumination source at each of a second plurality of point illumination locations within the illumination pupil, wherein each location in the first plurality of point illumination locations has a corresponding point symmetrical location in the second plurality of point illumination locations such that said first plurality of point illumination locations and said second plurality of point illumination locations together comprise a plurality of point symmetrical pairs of point illumination locations.

8. A method as claimed in claim 7, wherein said fiducial correction parameter is determined from pairs of said intensity parameter values, each pair of intensity parameter values comprising: an intensity parameter value from said first set of intensity parameter values and an intensity parameter value from said second set of intensity parameter values and corresponding to each of said point symmetric pairs of point illumination locations.

9. A method as claimed in claim 7 or 8, comprising capturing said first measurement data by scanning the at least one point illumination source over said first plurality of point illumination locations and said second plurality of point illumination locations, and obtaining an intensity parameter value from an image captured at each of said first and second plurality of point illumination locations .

10. A method as claimed in claim 9, wherein scanning said at least one point illumination source comprises moving at least one illumination aperture within said illumination pupil.

11. A method as claimed in claim 9, wherein scanning said at least one point illumination source comprises directing the at least one point illumination source over said first plurality of point illumination locations and said second plurality of point illumination locations using a directing element.

12. A method as claimed in any of claims 7 to 11, wherein said first set of intensity parameter values and said second set of intensity parameter values each relates to a first orientation of the fiducial target with respect to sensor optics used to obtain said first measurement data, and said first measurement data further comprises a fourth set of intensity parameter values and a fifth set of intensity parameter values, each relating to intensity values obtained using the at least one point illumination source at each of said first plurality of point illumination locations and said second plurality of point illumination locations respectively, for a second orientation of the fiducial target with respect to said sensor optics.

13. A method as claimed in any of claims 1 to 11, wherein said first measurement data relates to only a first orientation of the fiducial target.

14. A metrology apparatus for determining a characteristic of interest of a target, being operable to perform the method of any one of the claims 1 to 13, the metrology apparatus comprising a point illumination source, said point illumination source comprising:
a directing element operable to receive an illumination beam and controllably direct, within an illumination pupil of the metrology apparatus, the illumination beam onto a substrate.

15. A metrology apparatus as claimed in claim 25, wherein the directing element comprises a scanning mirror or spatial light modulator.

Fig. 1

Fig. 2

Fig. 3

Fig. 4

Fig. 5

Fig. 6

INL

SMF

SM

W

L2

L3

DET

BS

Ill

SC

L1

OB

FID

STA

$p_x$

IPP$_1$

$p_y$

IPP$_2$

PP

AP

Fig. 7

800

812

814

816

806

808

810

802

804

805

818

820

830

828

826

822

824

Fig. 8

Europäisches
Patentamt

European
Patent Office

Office européen
des brevets

## EUROPEAN SEARCH REPORT

Application Number

EP 21 16 9097

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 2012/123581 A1 (SMILDE HENDRIK JAN HIDDE [NL] ET AL) 17 May 2012 (2012-05-17) | 1,5-8, 10,12-15 | INV. G03F7/20 |
| Y | * paragraph [0064] - paragraph [0096] * <br> * figures 3,6,7 * | 2-4,9,11 | |
| Y | WO 2020/224882 A1 (ASML NETHERLANDS BV [NL]) 12 November 2020 (2020-11-12) | 2-4,9,11 | |
| A | * paragraph [0034] - paragraph [0042] * <br> * figure 4 * | 1,14 | |

TECHNICAL FIELDS
SEARCHED      (IPC)

G03F

The present search report has been drawn up for all claims

| Place of search | Date of completion of the search | Examiner |
|---|---|---|
| Munich | 12 October 2021 | Meixner, Matthias |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 21 16 9097

This annex lists the patent family members relating to the patent documents cited in the above-mentioned European search report.
The members are as contained in the European Patent Office EDP file on
The European Patent Office is in no way liable for these particulars which are merely given for the purpose of information.

12-10-2021

| Patent document cited in search report | | | Publication date | Patent family member(s) | | | Publication date |
|---|---|---|---|---|---|---|---|
| US 2012123581 | A1 | | 17-05-2012 | CN | 103201682 | A | 10-07-2013 |
| | | | | JP | 5661194 | B2 | 28-01-2015 |
| | | | | JP | 2014502420 | A | 30-01-2014 |
| | | | | KR | 20130094836 | A | 26-08-2013 |
| | | | | TW | 201229496 | A | 16-07-2012 |
| | | | | US | 2012123581 | A1 | 17-05-2012 |
| | | | | US | 2016033877 | A1 | 04-02-2016 |
| | | | | WO | 2012062858 | A1 | 18-05-2012 |
| WO 2020224882 | A1 | | 12-11-2020 | NL | 2025265 | A | 23-11-2020 |
| | | | | WO | 2020224882 | A1 | 12-11-2020 |

EPO FORM P0459

For more details about this annex : see Official Journal of the European Patent Office, No. 12/82

**EP 4 080 284 A1**

**REFERENCES CITED IN THE DESCRIPTION**

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 2006033921 A1
- US 2010201963 A1
- US 2006066855 A1
- WO 2009078708 A
- WO 2009106279 A
- US 20110027704 A
- US 20110043791 A
- US 20120123581 A
- US 20130258310 A
- US 20130271740 A
- WO 2013178422 A1
- US 7656518 B